# EUROPÄISCHE PATENTANMELDUNG

(11) **EP 2 107 618 A2**
(43) Veröffentlichungstag der Anmeldung: **07.10.2009**
(21) Anmeldenummer: 09157288.3
(22) Anmeldetag: 03.04.2009
(51) Int. Cl.: H01L 31/048, H01L 31/02

(54) **Solarzellenmodul**

(30) Priorität: 04.04.2008 DE 102008017522
(71) Anmelder: Günther Spelsberg GmbH & Co. KG, 58579 Schalksmühle (DE)
(72) Erfinder: Spelsberg, Holger, 58579, Schalksmühle (DE)
(74) Vertreter: Michalski, Stefan

(57) **Zusammenfassung**

Die Erfindung betrifft ein Solarzellenmodul 1, mit einer ein Kontaktelement 3 aufweisenden Solarzelle 2 und einem Anschlusselement 7 für einen elektrischen Anschluss des Solarzellenmoduls 1 sowie ein Herstellungsverfahren dafür. Erfindungsgemäß ist innerhalb des Solarzellenmoduls 1 eine elektrisch leitende Kontaktierung zwischen dem Kontaktelement 3 und dem Anschlusselement 7 vorgesehen. Damit wird eine Möglichkeit bereitgestellt, einen einfachen und sicheren Anschluss eines Solarzellenmoduls 1 zu erzielen.

## Beschreibung

Die Erfindung betrifft ein Solarzellenmodul, mit einer ein Kontaktelement aufweisenden Solarzelle und einem Anschlusselement für einen elektrischen Anschluss des Solarzellenmoduls sowie ein Verfahren zur Herstellung eines Solarzellenmoduls.

Solarzellenmodule haben in verschiedenen Anwendungsgebieten, wie bei Photovoltaik-Anlagen, eine große Bedeutung und dienen zur Umwandlung des Sonnenlichts in elektrische Energie. Dabei können Solarzellenmodule einzeln oder in Gruppen verschaltet sein. Weitere Anwendungsgebiete für Solarzellenmodule sind stromnetzunabhängige Verbraucher oder Raumfahrzeuge.

Für Photovoltaik-Anlagen wird im Allgemeinen eine Mehrzahl von Solarzellenmodulen verwendet, wobei ein jedes Solarzellenmodul aus einer Mehrzahl von Solarzellen aufgebaut ist. Für ein jeweiliges Solarzellenmodul sind die einzelnen Solarzellen in der Regel in Reihe geschaltet. Dazu werden die Frontseitenkontakte einer Solarzelle mit den Rückseitenkontakten der nächsten Solarzelle kontaktiert. Dadurch erhält man eine Reihenschaltung der Solarzellen, da jeweils der Minuspol auf der Vorderseite der einen Solarzelle mit dem Pluspol auf der Rückseite der folgenden Solarzelle verbunden wird. Der eigentliche elektrische Anschluss des Solarzellenmoduls erfolgt dann über die Kontakte der ersten bzw. letzten Solarzelle in der Reihenschaltung des Solarzellenmoduls.

Die Kontakte der Solarzellen, auch als Strings oder Ribbons bezeichnet, werden zum elektrischen Anschluss bisher aus dem Solarzellenmodul herausgeführt, typischerweise nämlich auf dessen Rückseite, indem eine dort vorgesehene Schutzschicht, im Allgemeinen in Form einer Schutzfolie, partiell geöffnet wird, so dass die Kontakte hindurchgeführt werden können. Die Kontakte werden dann in der Regel in eine Anschlussdose hineingeführt, die im Allgemeinen in wasserdichter Weise auf der Rückseite des Solarzellenmoduls vorgesehen ist.

Diese Vorgehensweise ist mit großem Aufwand verbunden und darüber hinaus fehleranfällig. Insbesondere kann nämlich nicht immer auf sichere Weise ausgeschlossen werden, dass an der Stelle, an der die Kontakte der Solarzellen aus dem Solarzellenmodul herausgeführt sind, kein Wasser eindringt oder es zu sonstigen Beschädigungen kommt. Ferner ist die Kontaktierung und Installation in der Anschlussdose auf diese Weise aufwendig und mitunter schwierig.

Vor diesem Hintergrund ist es die Aufgabe der Erfindung, eine Möglichkeit anzugeben, einen einfachen und sicheren Anschluss eines Solarzellenmoduls zu erzielen.

Ausgehend von dem eingangs beschriebenen Solarzellenmodul ist diese Aufgabe dadurch gelöst, dass innerhalb des Solarzellenmoduls eine elektrisch leitende Kontaktierung zwischen dem Kontaktelement und dem Anschlusselement vorgesehen ist.

Erfindungsgemäß ist also vorgesehen, dass die elektrisch leitende Kontaktierung des Solarzellenmoduls mit dem elektrischen Anschluss des Solarzellenmoduls derart erfolgt, dass die elektrisch leitende Kontaktierung zwischen dem Kontaktelement und dem Anschlusselement im Inneren des Solarzellenmoduls erfolgt. Diese Vorgehensweise dient insbesondere einer einfachen und universellen sowie sicheren elektrischen Kontaktierung sowie Einsetzbarkeit des Solarzellenmoduls, da anstatt einer aus dem Stand der Technik bekannten elektrischen Kontaktierung außerhalb des Solarzellenmoduls, welche vielfach fehleranfällig ist, ein völlig neuer Weg eingeschlagen wird, der eine Vielzahl von Nachteilen aus dem Stand der Technik vermeidet. Mit anderen Worten ermöglicht die Erfindung durch die Kontaktierung innerhalb des Solarzellenmoduls eine besonders sichere und fehlerunanfällige elektrische Kontaktierung des Solarzellenmoduls mit dem elektrischen Anschluss.

Gemäß einer bevorzugten Weiterbildung der Erfindung ist in diesem Zusammenhang vorgesehen, dass das Anschlusselement für die elektrisch leitende Kontaktierung mit dem Anschlusselement von außerhalb des Solarzellenmoduls in dieses eingeführt ist. Beispielsweise kann ein Rahmen vorgesehen sein, in den das Solarzellenmodul einsetzbar ist. Das Anschlusselement kann Teil des Rahmens sein und kann dann während des Einsetzens des Solarzellenmoduls in den Rahmen in das Solarzellenmodul eingeführt werden. Auf diese Weise wird eine besonders einfache Möglichkeit geschaffen, um beim Einsetzen des Solarzellenmoduls in den Rahmen eine elektrisch leitende Kontaktierung zwischen dem Kontaktelement und dem Anschlusselement zu schaffen.

Weiterhin ist gemäß einer bevorzugten Weiterbildung der Erfindung vorgesehen, dass das Kontaktelement zur Kontaktierung nicht aus dem Solarzellenmodul herausgeführt ist. Vorzugsweise ist das Kontaktelement dabei überhaupt nicht, also auch nicht für andere Zwecke, aus dem Solarzellenmodul herausgeführt. Vorteilhaft ist hieran insbesondere, dass das Kontaktelement beispielsweise während des Transports oder während der Installation nicht beschädigt werden kann.

Grundsätzlich kann das Anschlusselement auf verschiedene Weisen ausgeführt sein. Gemäß einer bevorzugten Weiterbildung der Erfindung ist jedoch vorgesehen, dass das Anschlusselement als Kontaktstift ausgeführt ist. Vorzugsweise ist der Kontaktstift dabei aus einem elektrisch gut leitenden Material wie Kupfer oder Eisen ausgeführt. Auf diese Weise wird erreicht, dass das Kontaktelement und das Anschlusselement eine gut leitende elektrische Verbindung aufweisen.

Ganz besonders ist es bevorzugt, dass das Anschlusselement als Dorn ausgeführt ist. Der Dorn, der vorzugsweise an der dem Kontaktelement zugeneigten Seite spitz zuläuft, kann von außerhalb in das Solarzellenmodul eindringen. Somit kann der Dorn selbständig durch eine möglicherweise vorhandene Schutzschicht und/oder der Rückwand in das Solarzellenmodul eindringen und die elektrisch leitende Kontaktierung mit dem Kontaktelement herstellen.

Gemäß einer weiteren Ausführungsform der Erfindung ist bevorzugt, dass das Anschlusselement durch die Rückseite des Solarzellenmoduls hindurch in dieses eingeführt ist. Dabei durchdringt das Anschlusselement das Material, aus der die Rückseite des Solarzellenmoduls ausgestaltet ist, beispielsweise eine Schutzfolie. Eine Kontaktierung durch die Rückseite des Solarzellenmoduls hindurch ist insofern vorteilhaft, als dass dadurch kein Platz auf der Vorderseite des Solarzellenmoduls benötigt wird, von welcher Seite her die Solarzellen typischerweise mit Sonnenlicht beaufschlagt werden.

Gemäß einer weiteren Ausführungsform der Erfindung ist bevorzugt, dass das Solarzellenmodul eine Verkapselung aufweist, das Kontaktelement von der Verkapselung umschlossen ist und das Anschlusselement durch die Verkapselung hindurch in das Solarzellenmodul eingeführt ist. Die Verkapselung kann aus einer transparenten Kunststoffschicht, wie beispielsweise Ethylenvinylacetat (EVA) ausgeführt sein und dient zum Schutz der Solarzellen. Mit anderen Worten durchdringt gemäß dieser bevorzugten Ausführungsform der Erfindung das Anschlusselement zur Herstellung der elektrisch leitenden Kontaktierung mit dem Kontaktelement die Verkapselung, von der die Solarzelle und damit auch das Kontaktelement umschlossen sind.

Grundsätzlich kann das Anschlusselement manuell, also beispielsweise während der Installation, in das Solarzellenmodul eingeführt sein. Gemäß einer bevorzugten Weiterbildung der Erfindung ist jedoch vorgesehen, dass das Anschlusselement mit Federkraft beaufschlagt in das Solarzellenmodul eingeführt ist. Dies ermöglicht insbesondere eine sehr einfache und sichere Kontaktierung, beispielsweise während des Einsetzens des Solarzellenmoduls in einen Rahmen.

Eine bevorzugte Weiterbildung der Erfindung liegt ferner darin, dass in dem Solarzellenmodul ein Isolierelement vorgesehen ist, wobei das Isolierelement dem mit Federkraft beaufschlagten Anschlusselement derart entgegenwirkt, dass es das Kontaktelement gegenüber der Frontseite des Solarzellenmoduls abstützt. Damit kann insbesondere sichergestellt werden, dass das mit Federkraft beaufschlage Anschlusselement das Kontaktelement nicht verbiegt und somit unbrauchbar macht, insbesondere bei der Installation des Solarzellenmoduls.

Gemäß einer bevorzugten Ausführungsform der Erfindung ist vorgesehen, dass in dem Solarzellenmodul eine Öffnung vorgesehen ist und das Anschlusselement durch die Öffnung hindurch in das Solarzellenmodul eingeführt ist. Das heißt beispielsweise, dass in der Rückseite des Solarzellenmoduls eine Öffnung vorgesehen sein kann, durch die hindurch das Anschlusselement in das Solarzellenmodul eingeführt ist. Insbesondere kann die Öffnung auch in der Verkapselung vorgesehen sein. Somit sind auch stumpfförmige Anschlusselemente zur elektrischen Kontaktierung einsetzbar.

Gemäß einer weiteren bevorzugten Ausführungsform der Erfindung ist vorgesehen, dass die Öffnung in einem Randbereich des Solarzellenmoduls vorgesehen ist. Ferner ist bevorzugt, dass der Anschluss von unten in das Solarzellenmodul eingeführt ist. Mit anderen Worten kann die elektrische Kontaktierung zwischen dem Kontaktelement und dem Anschlusselement in einem Randbereich des Solarzellenmoduls, also beispielsweise in einem Rahmen und/oder von unten, erfolgen. Dadurch ist eine Möglichkeit für eine sehr einfache Installation des Solarzellenmoduls gegeben.

Gemäß einer weiteren bevorzugten Ausführungsform der Erfindung ist ein Dichtungselement vorgesehen, wobei das Dichtungselement an der Rückseite des Solarzellenmoduls anliegt und das Anschlusselement umschließt. Das Dichtungselement ist vorzugsweise ausgeführt als spaltfüllende elastische Dichtmasse oder als dauerelastisches Dichtelement. Dabei dichtet das Dichtungselement die Rückseite des Solarzellenmoduls derart ab, dass keine Feuchtigkeit in die Öffnung eintreten kann, die zur Kontaktierung des Anschlusselements mit dem Kontaktelement vorgesehen ist oder durch die das Anschlusselement, beispielsweise ausgeführt als Dorn, in das Solarzellenmodul eindringt.

Gemäß einer bevorzugten Weiterbildung der Erfindung ist vorgesehen, dass ein das Solarzellenmodul wenigstens teilweise oder vorzugsweise vollständig umgebender Rahmen vorgesehen ist, die Frontseite des Solarzellenmoduls an der einen Seite des Rahmen anliegt und das Anschlusselement an der anderen Seite des Rahmens anliegt. Dazu kann der Rahmen insbesondere mehrteilig sein und dabei zum Beispiel zwei einander gegenüberliegende Längsteile, zwei einander gegenüberliegende Querteile und zur Verbindung dieser Teile miteinander insgesamt vier Eckteile aufweisen, wenn das Solarzellenmodul, wie im Allgemeinen üblich, in einer rechteckigen Form ausgebildet ist. Insbesondere kann das mit Federkraft beaufschlagte Anschlusselement an der anderen Seite des Rahmens anliegen. Mit anderen Worten kann ein Federelement oder eine Feder, die das Anschlusselement mit Federkraft beaufschlagt, an der anderen Seite des Rahmens anliegen.

Die weiter oben angegebene Aufgabe der Erfindung ist weiterhin gelöst durch ein Verfahren zur Herstellung eines Solarzellenmoduls, das eine ein Kontaktelement aufweisenden Solarzelle aufweist und wenigstens folgenden Schritt umfasst: Herstellen einer elektrisch leitenden Kontaktierung innerhalb des Solarzellenmoduls zwischen dem Kontaktelement und einem Anschlusselement für einen elektrischen Anschluss des Solarzellenmoduls.

Während die Kontaktierung von Kontaktelementen der Solarzellenmodule bisher sehr aufwändig und schwierig gewesen ist, nämlich häufig von Hand in einer Anschlussdose für ein Solarzellenmodul erfolgen musste, wird damit erfindungsgemäß eine sehr einfache und insbesondere auch verlässliche Möglichkeit der elektrischen Kontaktierung innerhalb des Solarzellenmoduls angegeben.

Das erfindungsgemäße Verfahren kann vor dem vorstehend beschriebenen Schritt mit zwei weiteren vorab auszuführenden Schritten aus- und weitergebildet sein. Vorzugsweise wird dazu in der Rückwand des Solarzellenmoduls eine Öffnung hergestellt, und das Anschlusselement wird von außerhalb des Solarzellenmoduls durch die Öffnung hindurch in das Solarzellenmodul eingeführt.

Gemäß einer bevorzugten Weiterbildung des erfindungsgemäßen Verfahrens kann in einem ersten Schritt eine Öffnung in der Rückwand des Solarzellenmoduls mittels eines als Dorn ausgebildeten Anschlusselements hergestellt werden. Somit wird die Öffnung, durch die das Anschlusselement in das Solarzellenmodul eindringt, erst unmittelbar vor oder bei der Installation des Solarzellenmoduls hergestellt werden, so dass während einer Lagerung oder eines Transports des Solarzellenmoduls keine Feuchtigkeit oder sonstige Verschmutzung in das Solarzellenmodul eindringen kann.

Weitere bevorzugte Ausgestaltungen des erfindungsgemäßen Verfahrens ergeben sich in Analogie zu den weiter oben beschriebenen bevorzugten Ausführungsformen des erfindungsgemäßen Solarzellenmoduls.

Die Erfindung wird nachfolgend unter Bezugnahme auf drei bevorzugte Ausführungsbeispiele der Erfindung anhand der Zeichnung weiter im Detail erläutert. In der Zeichnung zeigen:
- Fig. 1: ein für die Erfindung verwendbares Solarzellenmodul in einer Schnittdarstellung,
- Fig. 2: eine Kontaktierung eines Anschlusselements mit einem Kontaktelement eines Solarzellemoduls gemäß einem ersten bevorzugten Ausführungsbeispiel der Erfindung in einer Schnittdarstellung, und
- Fig. 3: eine Kontaktierung eines Anschlusselements mit einem Kontaktelement eines Solarzellenmoduls gemäß einem zweiten bevorzugten Ausführungsbeispiel der Erfindung in einer Schnittdarstellung.

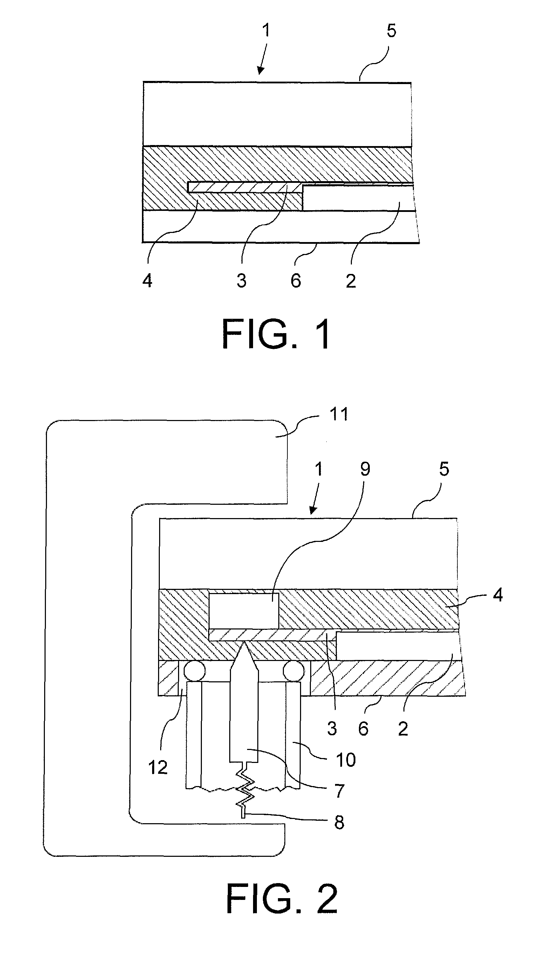

Aus Fig. 1 ist in Schnittdarstellung ein Solarzellenmodul 1 mit einer Frontseite 5 und einer Rückseite 6 ersichtlich. Hier ist das Solarzellenmodul 1 in einem Zustand gezeigt, in dem es ausgeliefert wird, also ohne elektrischen Anschluss. Das bedeutet, dass das in Fig. 1 dargestellte Solarzellenmodul 1 noch nicht mit einem elektrischen Anschluss elektrisch leitend verbunden ist. Das Solarzellenmodul 1 weist eine Solarzelle 2 und weitere nicht dargestellte Solarzellen auf. Die aus Fig. 1 ersichtliche Solarzelle 2 ist elektrisch leitend mit einem Kontaktelement 3 verbunden. Gemäß dem vorliegend beschriebenen Solarzellenmodul ist das Kontaktelement 3 von einer Verkapselung 4 aus EVA umschlossen.

Aus Fig. 2 ist nun eine weitere Schnittdarstellung ersichtlicht, die zeigt, wie eine Kontaktierung zwischen dem Kontaktelement 1 und dem Anschlusselement 7 gemäß einem ersten bevorzugten Ausführungsbeispiel der Erfindung erfolgt. Das Anschlusselement 7 ist mit der Federkraft einer Feder 8 beaufschlagt in das Solarzellenmodul 1 eingeführt. In dem Solarzellenmodul 1 ist ferner ein Isolierelement 9 vorgesehen, wobei das Isolierelement 9 derart angeordnet ist, dass es das mit Federkraft beaufschlagte Anschlusselement 7 gegenüber der Frontscheibe 5 des Solarzellenmoduls 1 abstützt. Weiterhin ist ein Dichtungselement 10 vorgesehen, welches das Anschlusselement 7 derart umfasst, dass keine Verschmutzung und/oder Feuchtigkeit in das Solarzellenmodul 1 eindringen kann.

Im hier vorliegend dargestellten Ausführungsbeispiel liegt die Frontseite 5 des Solarzellenmoduls 1 an einer Seite eines Rahmens 11 an. Das von der Federkraft beaufschlagte Anschlusselement 7 liegt an der anderen Seite des Rahmens 11 an. Die Rückseite 6 des Solarzellenmoduls 1 weist eine Öffnung 12 auf, durch die das Anschlusselement 7 in das Solarzellenmodul 1 eindringt. Der Durchmesser der Öffnung 12 ist derart bemessen, dass das Dichtungselement 10 ebenso wie das Anschlusselement 7 durch diese Öffnung 12 hindurch in das Solarzellenmodul 1 eingeführt ist, so dass das Dichtungselement 10 unmittelbar auf der Verkapselung 4 aufliegt.

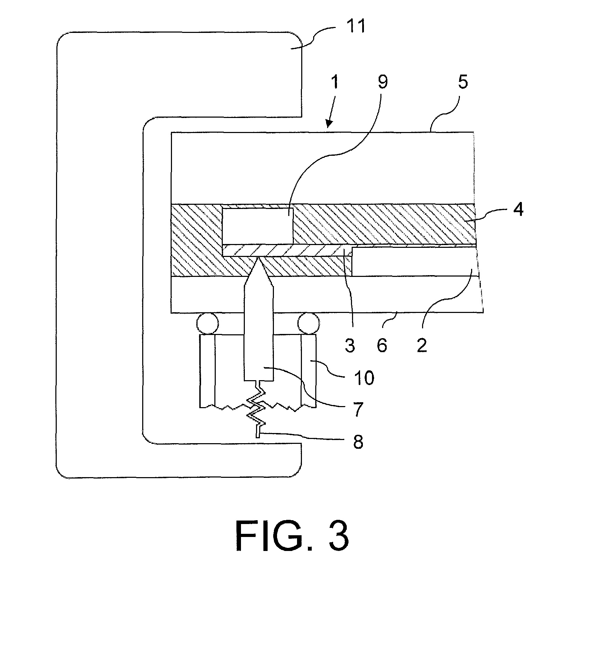

Gemäß einem zweiten bevorzugtem Ausführungsbeispiel der Erfindung, wie aus Fig. 3 ersichtlich, weist das Solarzellenmodul 1 keine Öffnung in der Rückwand 6 auf. Das Anschlusselement 7 ist vorliegend vielmehr als Dorn ausgeführt und dringt derart in das Solarzellenmodul 1 ein, dass es dabei die Rückwand 6 und die Verkapselung 4 durchsticht. In diesem Fall liegt das Dichtungselement 10 auf der Rückwand 6 des Solarzellenmoduls 1 auf.

Im Ergebnis wird somit auf einfache und verlässliche Weise eine Kontaktierung zwischen dem Kontaktelement und dem Anschlusselement ermöglicht, ohne dass das Kontaktelement aus dem Solarzellenmodul herausgeführt werden muss oder ohne dass aufwändige Installationsarbeiten innerhalb einer separat vorgesehenen Anschlussdose für das Solarzellenmodul durchgeführt werden müssen.

## Patentansprüche

1. Solarzellenmodul, mit einer ein Kontaktelement (3) aufweisenden Solarzelle (2) und einem Anschlusselement (7) für einen elektrischen Anschluss des Solarzellenmoduls (1)
**dadurch gekennzeichnet,**
**dass** innerhalb des Solarzellenmoduls (1) eine elektrisch leitende Kontaktierung zwischen dem Kontaktelement (3) und dem Anschlusselement (7) vorgesehen ist.

2. Solarzellenmodul (1) nach Anspruch 1, **dadurch gekennzeichnet, dass** das Anschlusselement (7) für die elektrisch leitende Kontaktierung mit dem Anschlusselement (7) von außerhalb des Solarzellenmoduls (1) in das Solarzellenmodul (1) eingeführt ist.

3. Solarzellenmodul (1) nach Anspruch 1 oder 2, **dadurch gekennzeichnet, dass** das Kontaktelement (3) zur Kontaktierung nicht aus dem Solarzellenmodul (1) herausgeführt ist.

4. Solarzellenmodul (1) nach einem der Ansprüche 1 bis 3, **dadurch gekennzeichnet, dass** das Anschlusselement (3) als Kontaktstift ausgeführt ist.

5. Solarzellenmodul (1) nach einem der Ansprüche 1 bis 3, **dadurch gekennzeichnet, dass** das Anschlusselement (3) als Dorn ausgeführt ist.

6. Solarzellenmodul (1) nach Anspruch 4 oder 5, **dadurch gekennzeichnet, dass** das Anschlusselement (3) durch die Rückseite (6) des Solarzellenmoduls (1) hindurch in das Solarzellenmodul (1) eingeführt ist.

7. Solarzellenmodul (1) nach Anspruch 6, **dadurch gekennzeichnet, dass** das Solarzellenmodul (1) eine Verkapselung (4) aufweist, das Kontaktelement (3) von der Verkapselung (4) umschlossen ist und das Anschlusselement (7) durch die Verkapselung (4) hindurch in das Solarzellenmodul (1) eingeführt ist.

8. Solarzellenmodul (1) nach Anspruch 6 oder 7, **dadurch gekennzeichnet, dass** das Anschlusselement (7) mit Federkraft (8) beaufschlagt in das Solarzellenmodul (1) eingeführt ist.

9. Solarzellenmodul (1) nach Anspruch 8, **dadurch gekennzeichnet, dass** in dem Solarzellenmodul (1) ein Isolierelement (9) vorgesehen ist, wobei das Isolierelement (9) dem mit Federkraft (8) beaufschlagten Anschlusselement (7) derart entgegenwirkt, dass es das Kontaktelement (3) gegenüber der Frontseite (5) des Solarzellenmoduls (1) abstützt.

10. Solarzellenmodul (1) nach Anspruch 9, **dadurch gekennzeichnet, dass** in dem Solarzellenmodul (1) eine Öffnung (12) vorgesehen ist und das Anschlusselement (7) durch die Öffnung (12) hindurch in das Solarzellenmodul (1) eingeführt ist.

11. Solarzellenmodul (1) nach Anspruch 9 oder 10, **dadurch gekennzeichnet, dass** die Öffnung (12) in einem Randbereich des Solarzellenmoduls (1) vorgesehen ist.

12. Solarzellenmoduls (1) nach einem der Ansprüche 9 bis 11, **dadurch gekennzeichnet, dass** das Anschlusselement (7) von unten in das Solarzellenmodul (1) eingeführt ist.

13. Solarzellenmodul (1) nach einem der Ansprüche 9 bis 12, **dadurch gekennzeichnet, dass** ein Dichtungselement (10) vorgesehen ist, wobei das Dichtungselement (10) an der Rückseite (6) des Solarzellenmoduls (1) anliegt und das Anschlusselement (7) umschließt.

14. Solarzellenmodul (1) nach einem der Ansprüche 9 bis 13, **dadurch gekennzeichnet, dass** ein das Solarzellenmodul (1) wenigstens teilweise oder vorzugsweise vollständig umgebender Rahmen (11) vorgesehen ist, die Frontseite (5) des Solarzellenmoduls (1) an der einen Seite des Rahmens (11) anliegt und das Anschlusselement (7) an der anderen Seite des Rahmens (11) anliegt.

15. Verfahren zur Herstellung eines Solarzellenmoduls (1), mit einer ein Kontaktelement 5 (3) aufweisenden Solarzelle (2), mit dem Schritt:
(c) Herstellen einer elektrisch leitenden Kontaktierung innerhalb des Solarzellenmoduls (1) zwischen dem Kontaktelement (3) und einem Anschlusselement (7) für einen elektrischen Anschluss des Solarzellenmoduls (1).
